(19) Europäisches Patentamt / European Patent Office / Office européen des brevets

(11) **EP 3 312 574 B1**

(12) **EUROPÄISCHE PATENTSCHRIFT**

(45) Veröffentlichungstag und Bekanntmachung des Hinweises auf die Patenterteilung:
**13.07.2022 Patentblatt 2022/28**

(21) Anmeldenummer: **16194931.8**

(22) Anmeldetag: **20.10.2016**

(51) Internationale Patentklassifikation (IPC):
**G01H 11/08** *(2006.01)*    **G01F 23/2965** *(2022.01)*
**G01K 7/34** *(2006.01)*

(52) Gemeinsame Patentklassifikation (CPC):
**G01F 23/2965; G01H 11/08; G01K 7/343**

(54) **VIBRATIONSSENSOR MIT INTEGRIERTER TEMPERATURERFASSUNG**

VIBRATION SENSOR WITH INTEGRATED TEMPERATURE DETECTION

DÉTECTEUR DE VIBRATION AVEC DÉTECTION DE TEMPÉRATURE INTÉGRÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.04.2018 Patentblatt 2018/17**

(73) Patentinhaber: **VEGA Grieshaber KG**
**77709 Wolfach (DE)**

(72) Erfinder:
* **Fehrenbach, Dominik**
**77716 Haslach (DE)**
* **Allgaier, Volker**
**77761 Haslach (DE)**

(74) Vertreter: **Patentanwälte Bauer Vorberg Kayser Partnerschaft mbB**
**Goltsteinstraße 87**
**50968 Köln (DE)**

(56) Entgegenhaltungen:
**EP-A1- 2 801 799**    **DE-A1- 19 805 184**
**JP-A- 2012 013 440**

* DAMJANOVIC D ET AL: "Ferroelectric sensors", IEEE SENSORS JOURNAL, IEEE SERVICE CENTER, NEW YORK, NY, US, Bd. 1, Nr. 3, 1. Oktober 2001 (2001-10-01) , Seiten 191-206, XP011402744, ISSN: 1530-437X, DOI: 10.1109/JSEN.2001.954832

**Beschreibung**

Die vorliegende Erfindung betrifft einen piezoelektrisch betriebenen Vibrationsgrenzschalter mit integrierter Temperaturerfassung gemäß dem Oberbegriff des Patentanspruchs 1.

Aus dem Stand der Technik sind Vibrationssensoren, die beispielsweise als Vibrationsgrenzschalter verwendet werden, bekannt, wobei der Vibrationssensor eine über einen Antrieb zu einer Schwingung anregbare Membran aufweist, mittels der ein an der Membran angeordneter mechanischer Schwinger zu einer Schwingung anregbar ist. Abhängig von einem Bedeckungsstand des mechanischen Schwingers mit einem Füllgut sowie abhängig von der Viskosität dieses Füllgutes schwingt der mechanische Schwinger mit einer charakteristischen Frequenz, die von dem Vibrationssensor detektiert werden und in ein Messsignal umgewandelt werden kann.

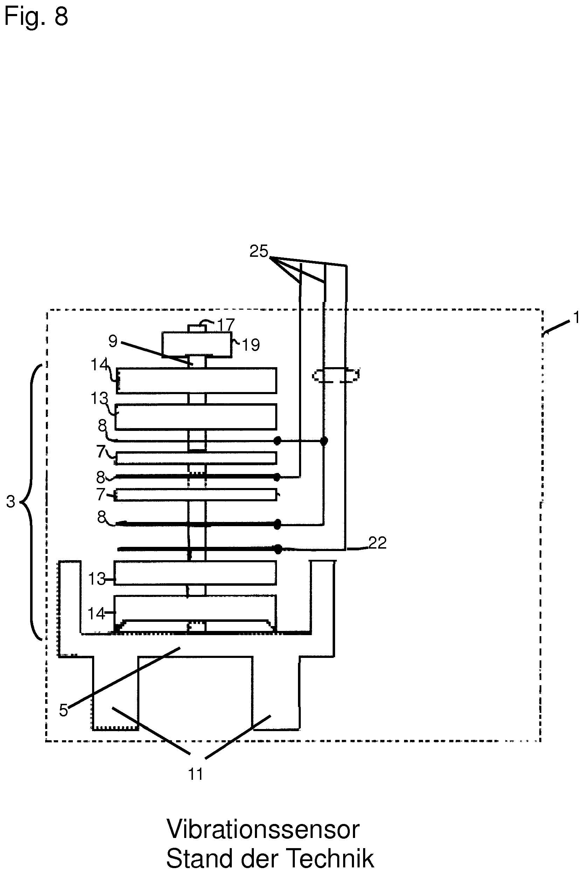

In Figur 8 ist ein aus dem Stand der Technik bekannter piezoelektrisch angetriebene Vibrationssensor 1, der insbesondere als Vibrationsgrenzschalter eingesetzt werden kann, gezeigt. Der Vibrationssensor weist eine über einen Antrieb 3 zu einer Schwingung anregbare Membran 5 auf, wobei der Antrieb 3 eine Mehrzahl von ringförmig ausgebildeten Piezoelementen 7 mit einer Öffnung 9 und eine elektrische Kontaktierung der Piezoelemente 7 umfasst. Typischerweise sind die Piezoelemente 7 über einen an der Membran 5 des Vibrationssensors 1 angeordneten Zugbolzen 17, der durch die Öffnung 9 der Piezoelemente 7 verläuft, über eine Spannschraube 19 gegen die Membran 5 gespannt, sodass eine über ein elektrisches Signal erzeugte Schwingung der Piezoelemente 7 zuverlässig auf die Membran 5 übertragen wird. Typischerweise sind zwischen den Piezoelementen 7 und der Membran 5 eine Anpasskeramik 13 und eine Spannscheibe 14 angeordnet, die für eine gezielte Einleitung der mechanischen Schwingung in die Membran 5 sowie eine elektrische Isolierung der Piezoelemente 7 gegenüber der typischerweise metallisch ausgebildeten Membran 5 sowie eine thermische Anpassung sorgt. Analog zu Anpasskeramik 13 und Spannscheibe 14 zwischen der Membran 5 und den Piezoelementen 7 kann ebenfalls eine weitere Anpasskeramik 13 und eine Spannscheibe 14 zwischen der Spannschraube 19 und den Piezoelementen 7 vorgesehen sein, sodass auch die Spannschraube 19 gegenüber den Piezoelementen 7 elektrisch isoliert ist.

Gegenüber dem Zugbolzen 17 können die Piezoelemente 7 über die in der Öffnung 9 angeordnete, vorliegend nicht höher gezeigte Hülse 10 isoliert sein.

Eine elektrische Kontaktierung der Piezoelemente 7 erfolgt über an den Oberflächen der Piezoelemente 7 angeordnete und über Kabel 25 von außen kontaktierte Elektroden 8.

Auf einer dem Antrieb 3 abgewandten Seite der Membran 5 sind typischerweise zwei als Paddel ausgebildete mechanische Schwinger 11 angeordnet, die die in die Membran 5 eingekoppelte Schwingung auf ein die mechanischen Schwinger 11 umgebendes Medium übertragen.

Vibrationssensoren der zuvor beschriebenen Art, insbesondere Vibrationsgrenzschalter für Flüssigkeiten arbeiten nach dem Prinzip der Resonanzfrequenzverschiebung. Der Vibrationsgrenzschalter schwingt je nach Bedeckungszustand, Dichte und Temperatur des Mediums mit einer anderen Resonanzfrequenz und Amplitude. Die Amplitude der Resonanzfrequenz ist dabei von der Viskosität des Mediums abhängig. Die Frequenzverschiebung ist von der Dichte und Temperatur des Mediums abhängig.

Damit die Einflüsse der Temperatur auf die Resonanzfrequenz kompensiert werden können, muss die Temperatur am Piezoantrieb und/oder des Schwingungselements bekannt sein.

Der Einfluss der Temperatur auf die Resonanzfrequenz ist durch die Materialkonstanten der verwendeten Materialen, insbesondere der Membran und des Schwingelements bekannt. Ist die Temperatur bekannt, kann also eine durch Temperatureinflüsse hervorgerufene Resonanzfrequenzverschiebung kompensiert werden. Im Stand der Technik wird im Antrieb ein Temperatursensor, in Figur 8 mit 22 bezeichnet, z.B. vom Typ PT100 mit verbaut.

Aus JP 2012-13440 A sind Anordnungen von zwei piezoelektrischen Elementen bekannt, die derart geschaltet werden können, dass die bei einer Vibration erzeugten elektrischen Ladungen sich gegenseitig aufheben und die beim Erwärmen erzeugten elektrischen Ladungen sich addieren, was eine Detektion und Messung einer Temperaturänderung möglich macht.

Bei den aus dem Stand der Technik bekannten Vibrationssensoren wird es dabei als nachteilig empfunden, dass zur Temperaturerfassung ein Temperatursensor als zusätzliches Bauelement mit zusätzlichem Platzbedarf, zusätzlichen Kosten sowie zusätzlicher Verkabelung notwendig ist.

Es ist die Aufgabe der vorliegenden Erfindung einen Vibrationssensor mit integrierter Temperaturerfassung dahingehend weiterzubilden, dass kein separater Sensor notwendig ist.

Diese Aufgabe wird durch einen Vibrationssensor mit den Merkmalen des Patentanspruchs 1 gelöst.

Vorteilhafte Weiterbildungen sind in abhängigen Patentansprüchen widergegeben.

Ein erfindungsgemäßer Vibrationssensor weist eine in Schwingung versetzbare Membran und einen piezoelektrischen Antrieb zum Versetzen der Membran in Schwingung und zum Erfassen von Schwingungen der Membran auf, wobei der Antrieb wenigstens zwei mechanisch in Serie geschaltete Piezoelemente aufweist. Solche Vibrationssensoren sind beispielsweise aus EP 2 801 799 A1 bekannt. Der erfindungsgemäße Vibrationssensor zeichnet sich dadurch aus, dass der Vibrationssensor eine integrierte Temperaturerfassung aufweist, wenigstens ein erstes Piezoelement aus einem ersten piezoelektrischen Material und wenigstens ein zweites Piezoelement aus einem zweiten piezoelektrischen Material ausgebildet ist und eine Temperatur durch Erfassen einer Kapazität wenigstens eines Piezoelements bestimmt wird.

Durch die Verwendung von wenigstens zwei Piezoelementen aus unterschiedlichen piezoelektrischen Materialien wird erreicht, dass die beiden unterschiedlichen Piezoelemente unterschiedliche Temperaturabhängigkeiten ihre Eigenschaften wie beispielsweise Kopplungsfaktor und Permittivität haben können. Auf diese Weise kann durch eine geeignete Materialzusammenstellung ein Vibrationssensor mit einem Antrieb zur Verfügung gestellt werden, der sowohl in einem großen Temperaturbereich einsetzbar ist als, auch eine integrierte Temperaturbestimmung ermöglicht.

Eine unterschiedliche Materialwahl ist notwendig, da Materialien, die einen über einen großen Temperaturbereich weitgehend konstanten oder nur in einem geringen Bereich schwankenden Kopplungsfaktor aufweisen in der Regel auch eine geringe Temperaturabhängigkeit ihrer dielektrischen Eigenschaften, also insbesondere der relativen Dielektrizitätszahl, aufweisen. Dagegen weisen piezoelektrische Materialien mit einer hohen Temperaturabhängigkeit der dielektrischen Eigenschaften, die sich damit gut zur Bestimmung einer Temperatur eignen, auch eine hohe Temperaturabhängigkeit des Kopplungsfaktors auf, wobei dieser insbesondere bei einer Annäherung an die Curietemperatur des jeweiligen Materials deutlich einbricht, sodass ein Wirkungsgrad des Antriebs damit deutlich zurückgeht.

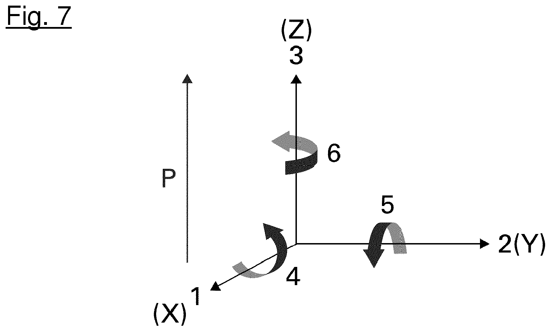

Zur Festlegung von Richtungen in Bezug auf die verwendeten Piezoelemente werden, wie dies in Figur 7 dargestellt ist, die Achsen 1, 2 und 3 eingeführt, die analog zu X-, Y- und Z-Achsen des katesischen Koordinatensystems ausgerichtet sind. Zusätzlich werden mit den Ziffern 4, 5 und 6 die Drehrichtungen um die jeweiligen Achsen, ebenfalls wie in Figur 7 eingezeichnet, bezeichnet. Die Achse 3 ist dabei entlang der Polarisierungsrichtung des jeweiligen Piezoelements ausgerichtet. Da das piezoelektrische Material anisotrop ist, werden die entsprechenden physikalischen Größen durch Tensoren beschrieben und entsprechend der obigen Achsennummerierung indiziert.

Der Kopplungsfaktor k ist ein Maß für die Ausprägung des piezoelektrischen Effekts. Er beschreibt das Vermögen eines piezoelektrischen Materials, aufgenommene elektrische Energie in mechanische Energie umzuwandeln und umgekehrt. Der Kopplungsfaktor berechnet sich dabei aus der Quadratwurzel des Verhältnisses von gespeicherter mechanischer Energie zur gesamten aufgenommenen Energie. Unter dynamischen Bedingungen hängt der Kopplungsfaktor k von der entsprechenden Schwingungsform des piezoelektrischen Körpers ab. Besonders relevant für piezoelektrische Antriebe von Vibrationssensoren der vorliegenden Art ist der Kopplungsfaktor der Longitudinalschwingung $k_{33}$, d. h. inwieweit ein Piezoelement eine in Richtung der Polarisation angelegte elektrische Spannung in eine Ausdehnung in Richtung der Achse 3, d. h. in Richtung der Polarisation überführt.

In gleicher Weise ist die Dielektrizitätszahl $\varepsilon$ bzw. die relative Dielektrizitätszahl $\varepsilon_r$ Richtungsabhängig. $\varepsilon_r$ beschreibt dabei das Verhältnis aus der Dielektrizitätszahl $\varepsilon$ des piezoelektrischen Materials und der Dielektrizitätskonstante $\varepsilon_0$, wobei die Dielektrizitätszahl $\varepsilon$ ein Maß für die Polarisierbarkeit des piezoelektrischen Materials im elektrischen Feld darstellt. Die Abhängigkeit der relativen Dielektrizitätszahl $\varepsilon_r$ von der Richtung des elektrischen Feldes und der dielektrischen Verschiebung wird ebenfalls durch entsprechende Indizies angezeigt. $\varepsilon_{33}$ beschreibt dabei die Dielektrizitätszahl $\varepsilon$ in Polarisationsrichtung bei ebenfalls in Polarisationsrichtung anliegenden elektrischem Feld.

Sofern in der vorliegenden Anmeldung von einem Kopplungsfaktor ohne explizite Indizierung oder Richtungsangabe gesprochen wird, so ist in diesen Fällen der Kopplungsfaktor in 33-Richtung, d. h. parallel zur Polarisierung des Piezoelements und in einer Richtung senkrecht zur Membran des Vibrationssensors gemeint. Dasselbe gilt für die relative Dielektrizitätszahl, die ohne explizit Indizierung und Richtungsangabe ebenfalls in 33-Richtung verstanden werden soll.

Erfindungsgemäß werden unterschiedlicher Materialien verwendet, wobei eine erste relative Dielektrizitätszahl des ersten piezoelektrischen Materials und eine zweite relative Dielektrizitätszahl des zweiten piezoelektrischen Materials eine unterschiedliche Temperaturabhängigkeit aufweisen. Insbesondere ist es vorteilhaft, wenn die erste relative Dielektrizitätszahl in 33-Richtung und die zweite relative Dielektrizitätszahl in 33-Richtung eine unterschiedliche Temperaturabhängigkeit aufweisen.

Ebenso ist es für die Materialkombination vorteilhaft, wenn ein erster Kopplungsfaktor in Richtung der Materialpolarisation des ersten piezoelektrischen Materials und ein zweiter Kopplungsfaktor in Richtung der Materialpolarisation des zweiten piezoelektrischen Materials eine unterschiedliche Temperaturabhängigkeit aufweisen. Durch entsprechend unterschiedliche Temperaturabhängigkeiten kann für den Antrieb eine Materialkombination gewählt werden, die für einen großen Temperaturbereich, beispielsweise von - 50° bis + 200°, vorteilhafterweise bis + 250° oder + 300°C in Summe einen für den Betrieb des Vibrationssensors ausreichenden Kopplungsfaktor aufweisen.

Wenn ein piezoelektrisches Material in die Nähe seiner Curietemperatur kommt, nimmt sein Kopplungsfaktor mit zunehmender Temperatur deutlich ab. Dieser Effekt tritt besonders stark ab etwa 70 % der Curietemperatur auf.

Vorteilhafterweise weist der erste Kopplungsfaktor in einem Temperaturbereich von - 50°C bis + 200°C eine annähernd lineare Temperaturabhängigkeit, d. h. Änderung relativ zur Temperatur auf.

Insbesondere kann der erste Kopplungsfaktor in dem Temperaturbereich eine relative Änderung von weniger als +/- 15%, vorzugsweise weniger als +/- 10% und weiter bevorzugt von gleich oder weniger als +/- 5% aufweisen. Ein solch lineares Verhalten bei einem annähernd konstanten Kopplungsfaktor stellt sicher, dass der piezoelektrische Antrieb für den gesamten Temperaturbereich zuverlässig einsetzbar ist.

Der erste Kopplungsfaktor kann in dem Temperaturbereich beispielsweise Werte in einem Bereich zwischen 10 und 20, vorzugsweise zwischen 15 und 20 aufweisen.

Der Kopplungsfaktor in 33-Richtung ist wie folgt definiert:

$$k_{33}^2 = \frac{W_{mech.,3}}{W_{elektr.,3}} = \frac{0.5 \cdot d_{33}^2 \cdot U_3^2 \cdot b \cdot h / (s_{33}^E \cdot l)}{0.5 \cdot U_3^2 \cdot \varepsilon_{33}^T \cdot b \cdot h / l} = \frac{d_{33}^2}{s_{33}^E \cdot \varepsilon_{33}^T}.$$

Wobei die verwendeten Formelbestandteile folgende Bedeutung aufweisen:

$K_{33}$ - Kopplungsfaktor in 33-Richtung
$W_{mech.,3}$ - mechanische Arbeit in 33-Richtung
$W_{elektr.,3}$ - elektrische Energie in 33-Richtung
$U_3$ - Elektrodenspannung in 33-Richtung
b - Piezobreite in 22-Richtung
h - Piezohöhe in 11-Richtung
l - Piezolänge in 33-Richtung
$d_{33}$ - Piezoelektrische Ladungskonstante in 33-Richtung
$s_{33}^E$ - Elastische Nachgiebigkeitskonstante in 33-Richtung
$\varepsilon_{33}^T$ - Relative Permitivitätszahl in 33-Richtung

Um eine möglichst gute Temperaturerfassung mit Hilfe einer Kapazitätsmessung des Antriebs insgesamt oder eines einzelnen Piezoelements zu gewährleiste ist es vorteilhaft, wenn die zweite relative Dielektrizitätszahl in dem Bereich eine relative Änderung von mehr als +/- 10%, vorzugsweise mehr als +/-15%, insbesondere in einem Bereich von - 10% bis + 30%, vorzugsweise in einem Bereich von - 10% bis + 50% aufweist. Durch eine entsprechend große Änderung der zweiten Dielektrizitätszahl des zweiten Piezoelements wird eine entsprechend große Änderung einer Kapazität eines Plattenkondensators, der mit den piezoelektrischen Elementen gebildet ist, erreicht, sodass mit hinreichender Genauigkeit eine Temperaturbestimmung erfolgen kann.

Vorzugsweise weist die zweite relative Dielektrizitätskonstante in dem Temperaturbereich eine Änderung von wenigstens 30%, vorzugsweise wenigstens 50%, insbesondere wenigstens 80% auf, wobei hier eine betragsmäßige Änderung über den gesamten Temperaturbereich gemeint sein soll.

Um einen hinreichend großen Kopplungsfaktor für den gesamten Antrieb über den gesamten Temperaturbereich hinweg zu gewährleisten, kann es vorteilhaft sein, wenn der Antrieb wenigstens zwei Piezoelemente aus dem ersten piezoelektrischen Material aufweist. Die Kopplungsfaktoren von mechanisch in Reihe geschalteten Piezoelementen addieren sich dabei zu einem Gesamtkopplungsfaktor des Antriebs.

Es ist vorteilhaft, wenn der Kopplungsfaktor des Antriebs in dem gesamten Temperaturbereich wenigstens 20, vorzugsweise wenigstens 25, weiter bevorzugt wenigstens 35 beträgt, da auf diese Weise bei einer vorgegebenen Vorspannung des Antriebs eine hinreichend mechanische Anregung der Membran erzielt werden kann.

Es kann dabei vorteilhaft sein, wenn das erste Piezoelement eine Curietemperatur von wenigstens 300°C, vorzugsweise wenigstens 320°C aufweist.

Das zweite Piezoelement kann dann beispielsweise eine Curietemperatur von 255°C und damit eine größere Temperaturabhängigkeit in dem Temperaturbereich aufweisen.

Typischerweise kommen für piezoelektrische Antriebe von Vibrationssensoren gemäß der vorliegenden Anmeldung piezoelektrische Materialien auf der Basis von Bleizirkonat - Bleititanat (PZT) zum Einsatz.

Die vorliegende Erfindung wird nachfolgend anhand von Ausführungsbeispielen und unter Bezugnahme auf die beigefügten Figuren eingehend erläutert.

Es zeigen:

Fig. 1    einen Längsschnitt durch einen Vibrationssensor gemäß der vorliegenden Anmeldung,

Fig. 2    ein elektrisches Ersatzschaltbild des Antriebs des Vibrationssensors aus Figur 1,

Fig. 3    eine relative Änderung des Kopplungsfaktors der Piezoelemente des Antriebs aus Figur 1 mit der Temperatur,

Fig. 4    eine absolute Änderung des Kopplungsfaktors der Piezoelemente des Antriebs aus Figur 1 mit der Temperatur,

Fig. 5    eine relative Änderung der Kapazität der Piezoelemente des Antriebs aus Figur 1,

Fig. 6    eine Änderung des Kopplungsfaktors mit der Temperatur für einen Antrieb mit drei Piezoelementen,

Fig. 7    ein Koordinatensystem wie es zur Bezeichnung der Richtungen von Polarisation, Kopplungsfaktor und relativer Dielektrizitätszahl verwendet wird (schon behandelt) und

Fig. 8    einen Vibrationssensor gemäß dem Stand der Technik (schon behandelt).

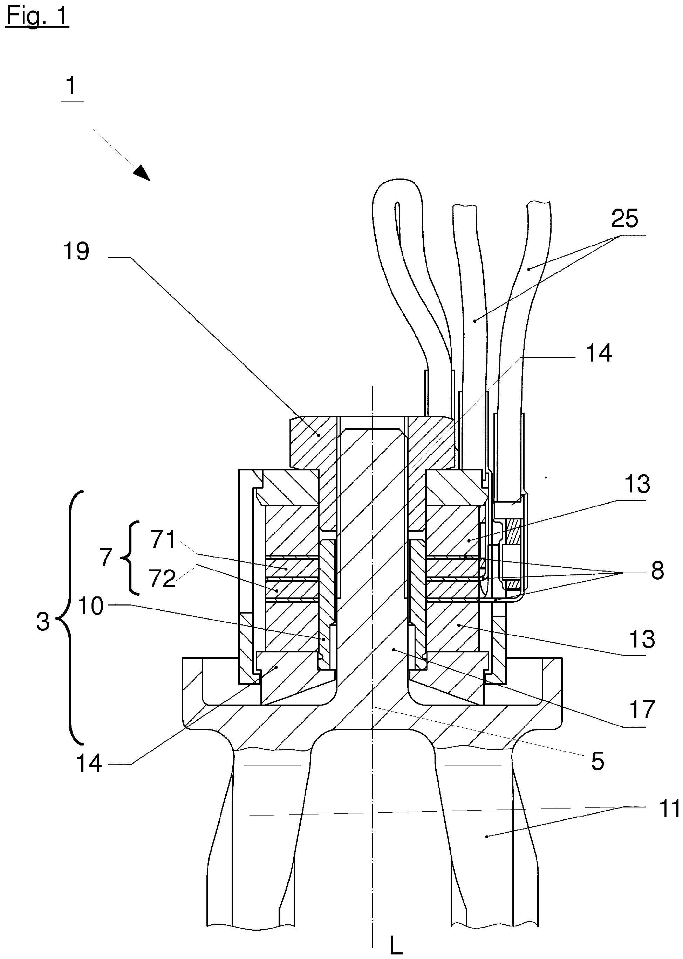

Figur 1 zeigt einen Längsschnitt durch einen Vibrationssensor 1 gemäß der vorliegenden Anmeldung. Ein Gehäuse sowie eine Sensorelektronik sind der besseren Übersichtlichkeit halber vorliegend nicht dargestellt.

Der gezeigte Vibrationssensor 1 besteht im Wesentlichen aus einem Antrieb 3, der mittels eines Zugbolzens 17 und einer Spannschraube 19 mit einer Membran 5 verschraubt ist. An einer dem Antrieb 3 gegenüberliegenden Seite der Membran 5 sind mechanische Schwinger 11, beispielsweise in Form von an der Membran 5 angeordneten und parallel zueinander ausgerichteten Paddeln angeordnet.

Zentraler Bestandteil des Antriebs 3 ist im vorliegenden Ausführungsbeispiel ein Stapel aus zwei Piezoelementen 7, die nachfolgend zu deren Unterscheidbarkeit als erstes Piezoelement 71 und zweites Piezoelement 72 bezeichnet werden. Die Piezoelemente 7 sind vorliegend ringförmig ausgebildet und umschließen damit den Zugbolzen 17 in Umfangsrichtung. Zur zentrierten Ausrichtung der Piezoelemente 7 sowie zu deren elektrischer Isolation gegenüber dem metallischen Zugbolzen 17 ist zwischen dem Zugbolzen 17 und den Piezoelementen 71 eine isolierende Hülse 10 angeordnet. Die Piezoelemente 7 sind über Elektroden 8 elektrisch kontaktiert, wobei eine elektrische Spannung über in rückseitiger Richtung verlaufende Kabel 25 geführt wird. Die Elektroden 8 kontaktieren jeweils eine in der vorliegenden Figur nicht näher dargestellte Oberflächenmetallisierung der Piezoelemente 7.

Unter vorderseitig wird in der vorliegenden Anmeldung eine Orientierung in Richtung der Membran 5, unter rückseitig eine Orientierung von der Membran 5 weggewandt verstanden.

Vorder- und rückseitig der Piezoelemente 7 ist jeweils eine Anpasskeramik 13 zur elektrischen Isolation angeordnet. Wiederum vorder- und rückseitig zu den jeweiligen Anpasskeramiken 13 sind Spannscheiben 14 angeordnet, mittels derer der Antrieb vorderseitig auf der Membran 5 aufsitzt und rückseitig mit Hilfe Spannschraube 19 mit dem Zugbolzen 17 verschraubt und damit in Richtung der Membran 5 vorgespannt ist.

Das erste Piezoelement 71 und das zweite Piezoelement 72 sind in dem in Figur 1 dargestellten Ausführungsbeispiel übereinandergestapelt und damit mechanisch in Reihe geschaltet. Das bedeutet, dass sich in Richtung einer Längsachse des Zugbolzens 17 ausbildende Längenänderungen des ersten Piezoelements 71 und des zweiten Piezoelements 72 innerhalb des Antriebs 3 addieren und damit ein vergrößerter Hub erreicht werden kann.

Bei einer mechanischen Reihenschaltung, wie dies in Figur 1 dargestellt ist, addieren sich die Kopplungsfaktoren der aufeinandergestapelten Piezoelemente 7 zu einem Gesamtkopplungsfaktor des Antriebs 3.

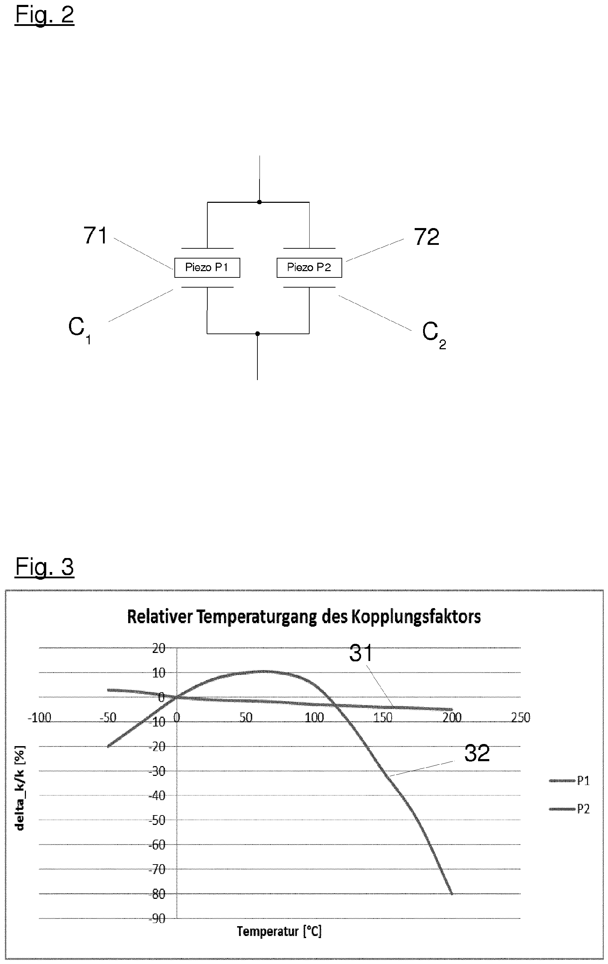

In Figur 2 ist ein elektrisches Ersatzschaltbild der Piezoelemente 7 aus Figur 1 dargestellt. Aus diesem Ersatzschaltbild ist ersichtlich, dass das erste Piezoelement 71 und das zweite Piezoelement 72 elektrisch gesehen parallel geschaltet sind.

Wie aus Figur 2 ersichtlich, bildet das erste Piezoelement 71 eine erste Kapazität $C_1$ und das zweite Piezoelement 72 eine zweite Kapazität $C_2$ aus. Durch die elektrische Parallelschaltung addieren sich die Kapazitäten $C_1$, $C_2$ aus. Durch die elektrische Parallelschaltung addieren sich die Kapazitäten $C_1$, $C_2$ zu einer Gesamtkapazität $C_{ges}$ des Antriebs 3.

Wie aus dem Ersatzschaltbild ersichtlich ist, sind die Piezoelemente 7 dabei als die Dielektrikum innerhalb der Plattenkondensatoren anzusehen, sodass eine Änderung der relativen Dielektrizitätszahl $\varepsilon_r$ des piezoelektrischen Materials des jeweiligen Piezoelements zu einer Änderung der Kapazität des zugeordneten Plattenkondensators führt. Auf diese Weise kann durch Bestimmung der Gesamtkapazität $C_{ges}$ des Antriebs 3 wie nachfolgend gezeigt wird eine Bestimmung der Temperatur der Piezoelemente mit hinreichender Genauigkeit erfolgen.

In Figur 3 ist ein relative Änderung des ersten Kopplungsfaktors $k_1$ und des zweiten Kopplungsfaktors $k_2$ des ersten Piezoelements 71 bzw. des zweiten Piezoelements 72 dargestellt. Gezeigt ist jeweils die Änderung des Kopplungsfaktors k in 33-Richtung der Piezoelemente, wobei eine Polarisation der Piezoelemente in Richtung der Längsachse L des Zugbolzens 17 und damit senkrecht zur Membran 5 ausgerichtet ist.

In Figur 3 ist mit 31 die Kennlinie der relativen Änderung des ersten Kopplungsfaktors $k_1$ des ersten Piezoelements 71 und mit 32 die relative Änderung des zweiten Kopplungsfaktors $k_2$ des zweiten Piezoelements 72 bezeichnet und gegenüber der Temperatur aufgetragen.

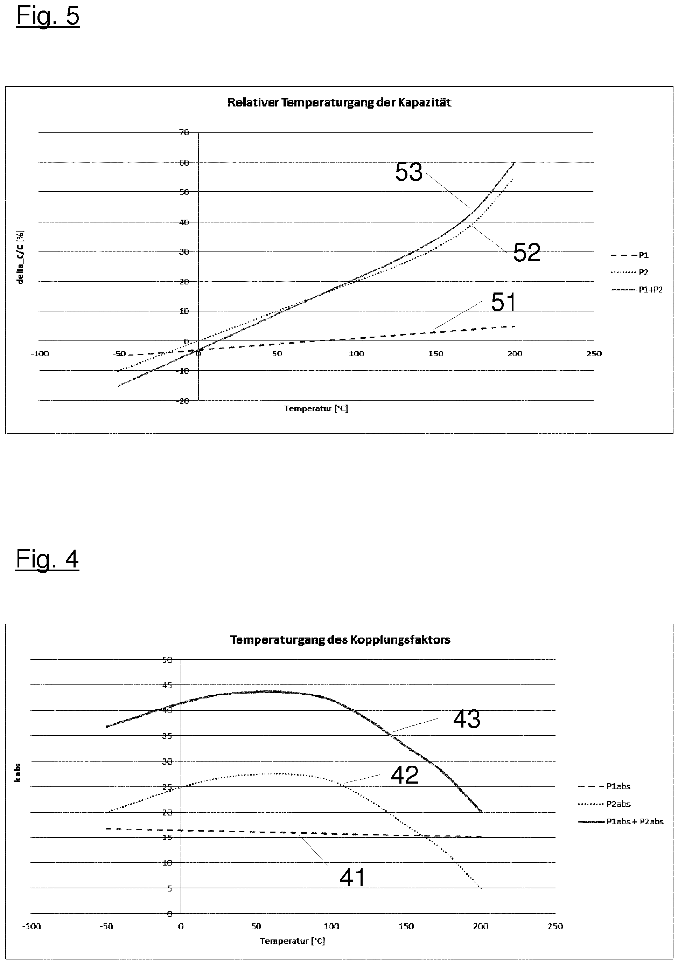

Wie aus Figur 3 ersichtlich, weist der erste Kopplungsfaktor $k_1$ in einem Temperaturbereich von - 50°C bis + 200°C eine relative Änderung von etwa +/- 5% auf, wobei der erste Kopplungsfaktor $k_1$ zusätzlich ein äußerst lineares Änderungsverhalten aufweist. Der zweite Kopplungsfaktor $k_2$ weist, wie aus Kennlinie 32 ersichtlich ist, ein nicht lineares Änderungsverhalten auf, wobei die Kennlinie 32 ausgehend von einer Relativänderung von - 20% bei - 50°C annähernd linear bis zum Nullpunkt ansteigt, anschließend bei etwa 60°C und + 10% ihr Maximum erreicht und mit weiter steigender Temperatur drastisch abfällt. Die Kennlinie 32 der relativen Änderung des zweiten Kopplungsfaktors $k_2$ schneidet dabei bei etwa 125°C erneut die X-Achse und fällt dann annähernd linear bis zu einem Wert von - 80% bei + 200°C ab. Es ist aus dieser Kennlinie ersichtlich, dass der zweite Kopplungsfaktor $k_2$ des zweiten Piezoelements 72 mit zunehmender Temperatur drastisch abnimmt. In Figur 4 ist die Temperaturabhängigkeit des ersten Kopplungsfaktors $k_1$ (Kennlinie 41), des zweiten Kopplungsfaktors $k_2$ (Kennlinie 42) sowie einer Summe aus dem ersten Kopplungsfaktor $k_1$ und dem zweiten Kopplungsfaktor $k_2$ (Kennlinie 43) dargestellt.

Aus Figur 4 ist dabei ersichtlich, dass sich erste Kopplungsfaktor $k_1$ in dem Temperaturbereich von - 50°C bis + 200°C annähernd linear von einem Wert von + 17 zu einem Wert von + 15 entwickelt.

Der zweite Kopplungsfaktor $k_2$ des zweiten Piezoelements 72 zeigt in dem genannten Temperaturbereich eine stärkere Temperaturabhängigkeit, wobei der Kopplungsfaktor beginnend bei einer Temperatur von - 50°C von + 20 auf etwa + 25 bei einer Temperatur von 0°C im Wesentlichen linear ansteigt, bei einer Temperatur von etwa 60°C mit +27,5 sein Maximum erreicht und anschließend bis zu einer Temperatur von 200°C auf etwa + 5 abfällt.

Mit der Kennlinie 43 ist die Temperaturabhängigkeit des Gesamtkopplungsfaktors $k_{ges}$ gezeigt. Der Gesamtkopplungsfaktor $k_{ges}$ ergibst sich dabei aus einer Addition des ersten Kopplungsfaktors $k_1$ und des zweiten Kopplungs-faktors $k_2$ des ersten Piezoelements 71 und des zweiten Piezoelements 72, was in den in Figur 4 dargestellten Diagramme eine Addition der Kennlinien 41 und 42 entspricht.

In Figur 5 ist die relative Änderung der ersten Kapazität $C_1$ (Kennlinie 51) der zweiten Kapazität $C_2$ (Kennlinie 52) sowie der Gesamtkapazität $C_{ges}$ (Kennlinie 53) gegenüber der Temperatur dargestellt. Die gleiche Kennlinie zeigt auch die relative Änderung der jeweiligen relativen Dielektrizitätszahl $\varepsilon_r$. Da unter der Annahme, dass eine Fläche A der Elektroden mittels derer die Piezoelemente 71, 72 kontaktiert werden sowie deren Abstand d im Wesentlichen gleich bleiben kürzen sich diese Werte aus der Formel zur Berechnung der Kapazität eines Plattenkondensators heraus, sodass lediglich die relative Änderung der relativen Dielektrizitätszahl verbleibt. Die Formel zur Berechnung der Kapazität eines Plattenkondensators ist

$$C = \varepsilon_0 \; x \; \varepsilon_r \; x \; A/d$$

Wobei $\varepsilon_0$ die dielektrische Konstante, $\varepsilon_r$ die relative Dielektrizitätszahl des Materials, A die Fläche der Elektrode und d der Abstand der Elektroden bezeichnet.

Aus Figur 5 geht damit hervor, dass sich die erste Kapazität $C_1$ des mit dem ersten Piezoelement 71 gebildeten Plattenkondensators im Temperaturbereich von - 50°C bis + 200°C im Wesentlichen linear in einem Bereich von +/- 5% ändert, wobei die Kapazität beginnend von - 5% bei - 50°C auf + 5% bei 200°C ansteigt.

Die zweite Kapazität $C_2$ des mit dem zweiten Piezoelement 72 gebildeten Plattenkondensators ändert sich im selben Temperaturbereich von - 10% auf + 55%, wobei in einem Temperaturbereich von - 50°C bis + 125°C ein im Wesentlichen linearer Anstieg von - 10% auf + 25% und anschließend ein ein Anstieg mit positiver Krümmung auf + 55% stattfindet. Die relative Temperaturabhängigkeit der Gesamtkapazität $C_{ges}$ des Antriebs 3 ist mit der Kennlinie 53 verdeutlicht. Die Kennlinie 53 ist dabei die Addition der Kennlinien 51 und 52, sodass die Gesamtkapazität $C_{ges}$ von - 15% auf + 60% bei 200°C ansteigt. Eine derartige Kapazitätsänderung kann mittels üblicher Verfahren gut ermittelt werden, sodass insbesondere jede Kapazitätsänderung eindeutig eine Temperatur zuordenbar ist, wodurch eine Temperaturbestimmung auf Basis einer Kapazitätsmessung ermöglicht wird.

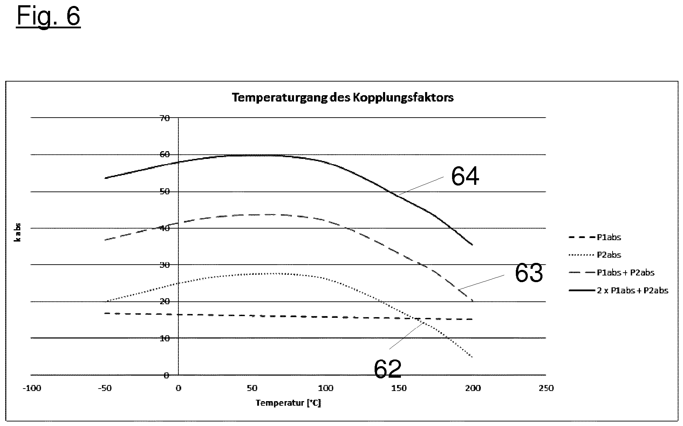

In Figur 6 ist für einen Antrieb mit zwei Piezoelementen aus dem ersten piezoelektrischen Material und einem Piezoelement aus dem zweiten piezoelektrischen Material, die bereits in Bezug auf Figur 4 erläuterte Temperaturabhängigkeit des Kopplungsfaktors k der einzelnen Piezoelemente sowie des Gesamtkopplungsfaktors gezeigt. Durch das Vorsehen von zwei Piezoelementen aus dem ersten piezoelektrischen Material wird der Gesamtkopplungsfaktor weiter nach oben geschoben, sodass insgesamt ein Kopplungsfaktor von über 35 über den gesamten Temperaturbereich erreicht wird.

In Kenntnis der vorliegenden Erfindung ist es dem Fachmann ohne Weiteres möglich, geeignete Materialkombinationen zur Erzielung eines hinreichenden Kopplungsfaktors über den gesamten Temperaturbereich bei gleichzeitig hinreichend großer Temperaturabhängigkeit eine Gesamtkapazität des Antriebs zu erreichen, sodass ohne zusätzliche Sensoren eine Temperaturbestimmung auf Basis einer Kapazitätsmessung möglich ist.

Bezugszeichenliste

1  Vibrationssensor

3    Antrieb

5    Membran

7    Piezoelemente
8    Elektroden
9    Öffnung
10   Hülse
11   mechanische Schwinger

13   Anpasskeramik
14   Spannscheibe

17   Zugbolzen

19   Spannschraube

22   Temperatursensor

25   Kabel

31   relative Änderung $k_1$
32   relative Änderung $k_2$

41   Änderung $k_1$
42   Änderung $k_2$
43   Änderung $k_{ges}$
71   erstes Piezoelement
72   zweites Piezoelement

$\varepsilon_0$    Dielektrizitätskonstante
$\varepsilon_{r1}$    erste relative Dielektrizitätszahl
$\varepsilon_{r2}$    zweite relative Dielektrizitätszahl

$k_1$    erster Kopplungsfaktor
$k_2$    Zweiter Kopplungsfaktor
$k_{ges}$    Gesamtkopplungsfaktor

$C_1$    erste Kapazität
$C_2$    zweite Kapazität
$C_{ges}$    Gesamtkapazität

L    Längsachse

**Patentansprüche**

**1.**  Vibrationssensor (1) mit

- einer in Schwingung versetzbaren Membran (5),
- einem piezoelektrischen Antrieb (3) zum Versetzen der Membran (3) in Schwingung und zur Erfassung von Schwingungen der Membran (3), wobei der Antrieb wenigstens zwei mechanisch in Serie geschaltete Piezoelemente (71, 72) aufweist,

**dadurch gekennzeichnet, dass**

der Vibrationssensor eine integrierte Temperaturerfassung aufweist, wenigstens ein erstes Piezoelement (71) aus einem ersten piezoelektrischen Material und wenigstens ein zweites Piezoelement (72) aus einem zweiten, piezoelektrischen Material ausgebildet ist , wobei der Vibrationssensor dazu ausgebildet ist, eine Temperatur durch Erfassen einer Kapazität wenigstens eines Piezoelements zu bestimmen, und wobei eine erste relative Dielektrizitätszahl ($\varepsilon_{r1}$) des ersten piezoelektrischen Materials und eine zweite relative Dielektrizitätszahl ($\varepsilon_{r2}$) des zweiten piezoelektrischen Materials eine unterschiedliche Temperaturabhängigkeit aufweisen.

2. Vibrationssensor (1) gemäß Anspruch 1,
   **dadurch gekennzeichnet, dass**
   eine erster Kopplungsfaktor ($k_1$) in Richtung der Materialpolarisation des ersten piezoelektrischen Materials und eine zweiter Kopplungsfaktor ($k_2$) in Richtung der Materialpolarisation des zweiten piezoelektrischen Materials eine unterschiedliche Temperaturabhängigkeit aufweisen.

3. Vibrationssensor (1) gemäß Anspruch 2,
   **dadurch gekennzeichnet, dass**
   der erste Kopplungsfaktor ($k_1$) in einem Temperaturbereich von -50°C bis +200°C eine annähernd lineare Änderung aufweist.

4. Vibrationssensor gemäß Anspruch 3,
   **dadurch gekennzeichnet, dass**
   der erste Kopplungsfaktor ($k_1$) in dem Temperaturbereich eine relative Änderung von weniger als +/- 15%, vorzugsweise weniger als +/-10% und weiter bevorzugt von gleich oder weniger als +/- 5% aufweist.

5. Vibrationssensor (1) gemäß Anspruch 4,
   **dadurch gekennzeichnet, dass**
   der erste Kopplungsfaktor ($k_1$) in dem Temperaturbereich Werte in einem Bereich zwischen 10 und 20, vorzugsweise zwischen 15 und 20 aufweist.

6. Vibrationssensor (1) gemäß einem der Ansprüche 4 oder 5,
   **dadurch gekennzeichnet, dass**
   die zweite relative Dielektrizitätszahl ($\varepsilon_{r2}$) in dem Temperaturbereich eine relative Änderung von mehr als +/-10%, vorzugsweise mehr als +/- 15%, insbesondere von wenigstens - 10% bis + 30%, vorzugsweise wenigstens +50% aufweist.

7. Vibrationssensor (1) gemäß einem der vorhergehenden Ansprüche,
   **dadurch gekennzeichnet, dass**
   die zweite relative Dielektrizitätszahl in dem Temperaturbereich eine Änderung von wenigstens 30%, vorzugsweise wenigstens 50%, insbesondere wenigstens 80% aufweist.

8. Vibrationssensor (1) gemäß einem der vorhergehenden Ansprüche,
   **dadurch gekennzeichnet, dass**
   der Antrieb (3) wenigstens zwei Piezoelemente (71, 72) aus dem ersten piezoelektrischen Material aufweist.

9. Vibrationssensor (1) gemäß einem der vorhergehenden Ansprüche,
   **dadurch gekennzeichnet, dass**
   der Antrieb (3) einen Kopplungsfaktor von wenigstens 20, vorzugsweise wenigstens 35 aufweist.

10. Vibrationssensor (1) gemäß einem der vorhergehenden Ansprüche,
    **dadurch gekennzeichnet, dass**
    ein membranseitiges Piezoelement (71) aus dem zweiten piezoelektrischen Material ist.

11. Vibrationssensor (1) gemäß einem der vorhergehenden Ansprüche,
    **dadurch gekennzeichnet, dass**
    das erste Piezoelement (71) eine Curietemperatur von wenigstens 300°C, vorzugsweise wenigstens 320°C ausweist.

12. Vibrationssensor (1) gemäß einem der vorhergehenden Ansprüche,
    **dadurch gekennzeichnet, dass**
    das zweite Piezoelement (72) eine Curietemperatur von 255°C aufweist.

## Claims

1. A vibration sensor (1) comprising

   - a diaphragm (5) that can be caused to vibrate,
   - a piezoelectric drive (3) for causing the diaphragm (3) to vibrate and for detecting vibrations of the diaphragm (3), wherein the drive includes at least two piezo elements (71, 72) mechanically connected in series,

   **characterized in that**
   the vibration sensor includes an integrated temperature detection, at least one piezo element (71) is formed from a first piezoelectric material and at least one second piezo element (72) is formed from a second piezoelectric material, wherein the vibration sensor is configured for determining a temperature by detecting a capacitance of at least one piezo element, and wherein the first relative permittivity ($\varepsilon_{r1}$) of the first piezoelectric material and a second relative permittivity ($\varepsilon_{r2}$) of the second piezoelectric material have different temperature dependencies.

2. The vibration sensor (1) according to claim 1,
   **characterized in that**
   a first coupling factor ($k_1$) in the direction of the material polarization of the first piezoelectric material and a second coupling factor ($k_2$) in the direction of the material polarization of the second piezoelectric material have different temperature dependencies.

3. The vibration sensor (1) according to claim 2,
   **characterized in that**
   the first coupling factor ($k_1$) exhibits an approximately linear change in a temperature range from -50°C to +200°C.

4. The vibration sensor according to claim 3,
   **characterized in that**
   the first coupling factor ($k_1$) exhibits, within the temperature range, a relative change of less than +/- 15%, preferably less than +/- 10%, and more preferably of equal to or less than +/- 5%.

5. The vibration sensor (1) according to claim 4,
   **characterized in that**
   the first coupling factor ($k_1$) has values in a range of between 10 and 20, preferably between 15 and 20, within the temperature range.

6. The vibration sensor (1) according to any one of the claims 4 or 5,
   **characterized in that**
   the second relative permittivity ($\varepsilon_{r2}$) exhibits, within the temperature range, a relative change of more than +/- 10%, preferably more than +/- 15%, particularly of at least -10% to + 30%, preferably of at least +/- 50%.

7. The vibration sensor (1) according to any one of the preceding claims,
   **characterized in that**
   the second relative permittivity exhibits, within the temperature range, a change of at least 30%, preferably of at least 50%, particularly of at least 80%.

8. The vibration sensor (1) according to any one of the preceding claims,
   **characterized in that**
   the drive (3) has at least two piezo elements (71, 72) consisting of the first piezoelectric material.

9. The vibration sensor (1) according to any one of the preceding claims,
   **characterized in that**
   the drive (3) has a coupling factor of at least 20, preferably of at least 35.

10. The vibration sensor (1) according to any one of the preceding claims,
    **characterized in that**
    a diaphragm-side piezo element (71) consists of the second piezoelectric material.

11. The vibration sensor (1) according to any one of the preceding claims,

**characterized in that**
the first piezo element (71) has a Curie temperature of at least 300°C, preferably of at least 320°C.

**12.** The vibration sensor (1) according to any one of the preceding claims,
**characterized in that**
the second piezo element (72) has a Curie temperature of 255°C.

**Revendications**

**1.** Capteur de vibrations (1) comprenant

- une membrane (5) apte à être mise en vibration,
- un entraînement piézoélectrique (3) destiné à mettre en vibration la membrane (3) et à détecter des vibrations de la membrane (3), dans lequel ledit entraînement comprend au moins deux éléments piézoélectriques (71, 72) montés mécaniquement en série,

**caractérisé en ce que** le capteur de vibrations présente une détection de température intégrée, au moins un premier élément piézoélectrique (71) est réalisé à partir d'un premier matériau piézoélectrique et au moins un deuxième élément piézoélectrique (72) est réalisé à partir d'un deuxième matériau piézoélectrique, dans lequel le capteur de vibrations est conçu pour déterminer une température en détectant une capacité d'au moins un élément piézoélectrique, et
dans lequel une première permittivité relative ($\varepsilon_{r1}$) du premier matériau piézoélectrique et une deuxième permittivité relative ($\varepsilon_{r2}$) du deuxième matériau piézoélectrique présentent une dépendance de température différente.

**2.** Capteur de vibrations (1) selon la revendication 1, **caractérisé en ce qu'**un premier facteur de couplage ($k_1$) dans la direction de la polarisation matérielle du premier matériau piézoélectrique et un deuxième facteur de couplage ($k_2$) dans la direction de la polarisation matérielle du deuxième matériau piézoélectrique présentent une dépendance de température différente.

**3.** Capteur de vibrations (1) selon la revendication 2, **caractérisé en ce que** le premier facteur de couplage ($k_1$) présente une variation approximativement linéaire dans une plage de température allant de -50 °C à +200 °C.

**4.** Capteur de vibrations selon la revendication 3, **caractérisé en ce que** le premier facteur de couplage ($k_1$) présente dans la plage de température une variation relative inférieure à +/- 15 %, de préférence inférieure à +/- 10 % et plus préférentiellement égale ou inférieure à +/- - 5%.

**5.** Capteur de vibrations (1) selon la revendication 4, **caractérisé en ce que** le premier facteur de couplage ($k_1$) présente des valeurs comprises entre 10 et 20, de préférence entre 15 et 20, dans la plage de température.

**6.** Capteur de vibrations (1) selon l'une quelconque des revendications 4 ou 5, **caractérisé en ce que** la deuxième permittivité relative ($\varepsilon_{r2}$) présente dans la plage de température une variation relative supérieure à +/- 10 %, de préférence supérieure à +/-15 %, en particulier d'au moins -10% à +30%, de préférence d'au moins +50%.

**7.** Capteur de vibrations (1) selon l'une quelconque des revendications précédentes, **caractérisé en ce que** la deuxième permittivité relative présente dans la plage de température une variation d'au moins 30 %, de préférence d'au moins 50 %, en particulier d'au moins 80 %.

**8.** Capteur de vibrations (1) selon l'une quelconque des revendications précédentes, **caractérisé en ce que** l'entraînement (3) comprend au moins deux éléments piézoélectriques (71, 72) réalisés dans le premier matériau piézoélectrique.

**9.** Capteur de vibrations (1) selon l'une quelconque des revendications précédentes, **caractérisé en ce que** l'entraînement (3) présente un facteur de couplage d'au moins 20, de préférence d'au moins 35.

**10.** Capteur de vibrations (1) selon l'une quelconque des revendications précédentes, **caractérisé en ce qu'**un élément piézoélectrique (71)côté membrane est réalisé dans le deuxième matériau piézoélectrique.

**11.** Capteur de vibrations (1) selon l'une quelconque des revendications précédentes, **caractérisé en ce que** le premier élément piézoélectrique (71) présente une température de Curie d'au moins 300 °C, de préférence d'au moins 320 °C.

**12.** Capteur de vibrations (1) selon l'une quelconque des revendications précédentes, **caractérisé en ce que** le deuxième élément piézoélectrique (72) présente une température de Curie de 255 °C.

<u>Fig. 1</u>

## Fig. 2

## Fig. 3

Relativer Temperaturgang des Kopplungsfaktors

EP 3 312 574 B1

Fig. 5

Relativer Temperaturgang der Kapazität

Fig. 4

Temperaturgang des Kopplungsfaktors

14

## Fig. 6

Temperaturgang des Kopplungsfaktors

Fig. 7

Fig. 8

Vibrationssensor
Stand der Technik

**IN DER BESCHREIBUNG AUFGEFÜHRTE DOKUMENTE**

**In der Beschreibung aufgeführte Patentdokumente**

- JP 2012013440 A
- EP 2801799 A1